# EUROPEAN PATENT APPLICATION

(11) **EP 2 868 769 A1**
(43) Date of publication of application: **06.05.2015**
(21) Application number: 13808892.7
(22) Date of filing: 12.06.2013
(51) Int. Cl.: C23C 14/54, C23C 14/12

(54) **FILM FORMATION DEVICE**

(30) Priority: 29.06.2012 JP 2012147802
(71) Applicant: ULVAC, Inc., Chigasaki-shi, Kanagawa 253-8543 (JP)
(72) Inventor: SAITOU, Kazuhiko, Chigasaki-shi Kanagawa 253-8543 (JP); IIJIMA, Masayuki, Chigasaki-shi Kanagawa 253-8543 (JP); HIRONO, Takayoshi, Chigasaki-shi Kanagawa 253-8543 (JP); NAKAMORI, Kenji, Chigasaki-shi Kanagawa 253-8543 (JP)
(74) Representative: Körber, Martin Hans
(86) International application number: PCT/JP2013/066261
(87) International publication number: WO 2014/002773

(57) **Abstract**

The present invention is to provide a technology for forming an organic compound film having a uniform thickness on a film at a high film formation speed while transporting the film in a vacuum chamber. In a vacuum chamber 2, a film 10 reeled out from a mother roll 41 is transported in contact with a center roller 3 and an organic compound film is formed on the film 10. A vapor emission device 8 disposed in a film deposition chamber 6 provided in the vacuum chamber 2 and having a vapor emission unit 82 which emits and blows a vapor of an organic compound monomer to a film 10 on the center roller 3; and an energy ray-emitting device 9 for irradiating an organic compound monomer layer formed on the center roller 3 with an energy ray so as to cure the organic compound layer are provided. The vapor emission device 8 and the film deposition chamber 6 are respectively connected to fifth and third vacuum evacuation devices 80 and 60 which are independently controllable; and the pressure in the vapor emission device 8 is set to be larger than the pressure in the film deposition chamber 6. The difference between the pressure in the vapor emission device 8 and the pressure in the film deposition chamber 6 is set to be constant.

## Description

### Technical Field

The present invention generally relates to a technology of a film formation device for forming an organic compound film on a film in a vacuum.

### Background Art

In recent years, there has been a demand for effectively forming electronic parts or the like on a film; and thus there is proposed a technology for forming a film composed of a polymer organic compound on the film by transporting a film of a long sheet in a vacuum chamber (for example, refer to Japanese Patent No. 3502261).

Conventionally, when a polymer organic compound film is formed on a film, for example, a low-molecular-weight organic compound monomer or the like is coated on a film to thereby form an organic compound layer, and the organic compound layer is cured by being heated or irradiated with an energy ray so as to form a polymer organic compound film.

However, in the case of forming a polymer organic compound film on a film by such a method in a vacuum chamber, there are various problems.

More particuarly, it is difficult to form, in a uniform thickness, a film of a monomer or the like of a low-molecular-weight organic compound on a film in a vacuum chamber, and in particular, it is very difficult to form, at a high film formation speed, an organic compound film having a uniform thickness on a film while transporting the film.
[Patent Literature 1] Japanese Patent No. 3502261

### Disclosure of the Invention

### Problems to be Solved by the Invention

The present invention has been accomplished while considering problems of a conventional technology, and a purpose thereof is to provide a technology for forming, at a high film formation speed, an organic compound film having a uniform thickness on a film while transporting the film in a vacuum chamber.

### Means for Solving the Problems

The present invention accomplished to achieve the above-mentioned purpose is a film formation device for transporting a film reeled out from a mother roll in contact with a center roller and forming an organic compound film on the film in a vacuum chamber. The device includes a vapor emission device disposed in a film deposition chamber provided in the vacuum chamber and having a vapor emission unit which emits and blows a vapor of an organic compound to a film on the center roller; and an energy ray-emitting device for irradiating an organic compound layer formed on the center roller with an energy ray so as to cure the organic compound layer. In the present invention, the vapor emission device and the film deposition chamber are respectively connected to vacuum evacuation devices that are controllable independently, and vacuum evacuation is performed such that the pressure in the vapor emission device becomes larger than the pressure in the film deposition chamber and the difference between the pressure in the vapor emission device and the pressure in the film deposition chamber becomes constant.

The present invention is also effective in that a flow rate of a rare gas which is controlled to a predetermined temperature is controlled so as to supply to the vapor emission device.

The present invention is also effective in the case where a curing chamber in which the energy ray-emitting device is disposed and a buffer chamber communicated with the curing chamber and the film deposition chamber are provided in the vacuum chamber, and the curing chamber and the buffer chamber are respectively connected to vacuum evacuation devices that are independently controllable.

In the present invention, when the vapor of an organic compound is emitted from the vapor emission unit of the vapor emission device and is blown against the film on the center roller, the vacuum evacuation is performed in a manner such that the pressure in the vapor emission device becomes larger than the pressure in the film deposition chamber and the difference between the pressure in the vapor emission device and the pressure in the film deposition chamber becomes constant; and thus, an organic compound layer having a uniform thickness can be formed on a film transported by the center roller.

As a result, according to the present invention, a polymer organic compound film having a uniform thickness can be formed by irradiating the organic compound layer having a uniform thickness with an energy ray so as to polymerize and cure the organic compound layer.

In the present invention, when a configuration is made such that a rare gas controlled to a predetermined temperature is supplied to the vapor emission device while controlling the flow amount of the rare gas, the pressure in the vapor emission device can easily be made larger than the pressure in the film deposition chamber; and thus, the film formation speed can be enhanced by the increase in the pressure difference between the vapor emission device and the film deposition chamber.

Furthermore, in the present invention, when the curing chamber in which an energy ray-emitting device is disposed and the buffer chamber communicated with the curing chamber and the film deposition chamber are provided in the vacuum chamber, and the curing chamber and the buffer chamber are respectively connected to vacuum evacuation devices which are independently controllable, differential exhaust with a large pressure difference can be performed not only between the vapor emission device and the film deposition chamber but also between the film deposition chamber, the buffer chamber and the curing chamber, so that the film formation speed can be enhanced by making the pressure difference between respective chambers larger.

### Effect of the Invention

According to the present invention, an organic compound film having a uniform thickness can be formed on a film transported by a center roller, in a vacuum chamber.

### Brief Description of the Drawings

Fig. 1(a) is an overall view showing the internal configuration of an embodiment of the film formation device according to the present invention; and Fig. 1(b) is an essential part configuration view of the same film formation device.
Fig. 2 (a) is a front view showing the vapor emission unit of the vapor emission device; and Fig. 2 (b) is a side view showing the vapor emission unit of the vapor emission device.
Figs. 3 (a) and 3(b) are explanatory views showing schematically a process of forming an organic compound layer on a film.

### Preferred embodiment of the invention

Hereinafter, preferable embodiments of the present invention will be explained while referring to the drawings.

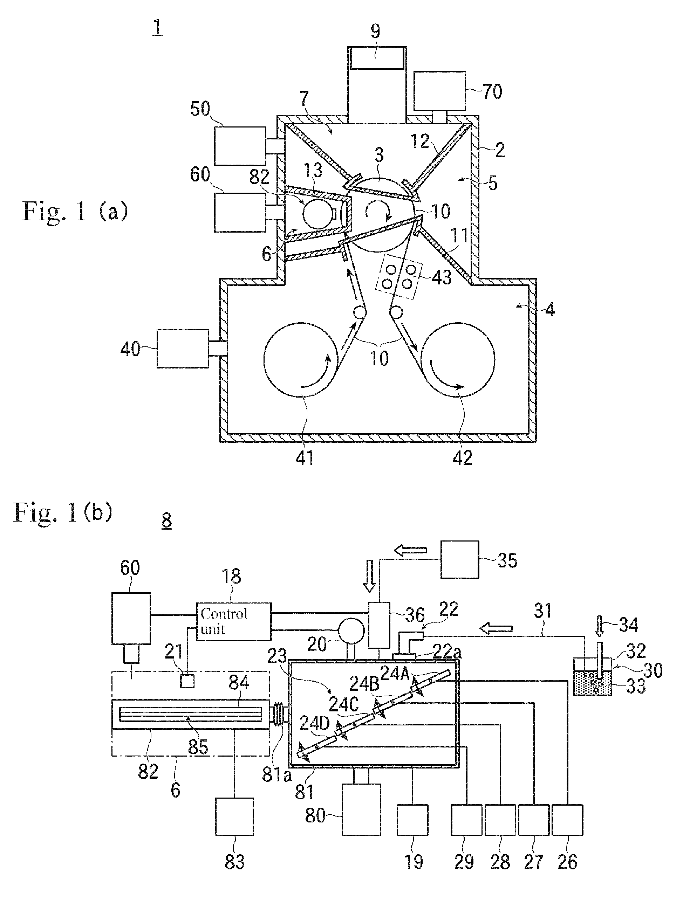

Fig. 1(a) is an overall view showing the internal configuration of an embodiment of the film formation device according to the present invention; and Fig. 1(b) is an essential part configuration view of the same film formation device.

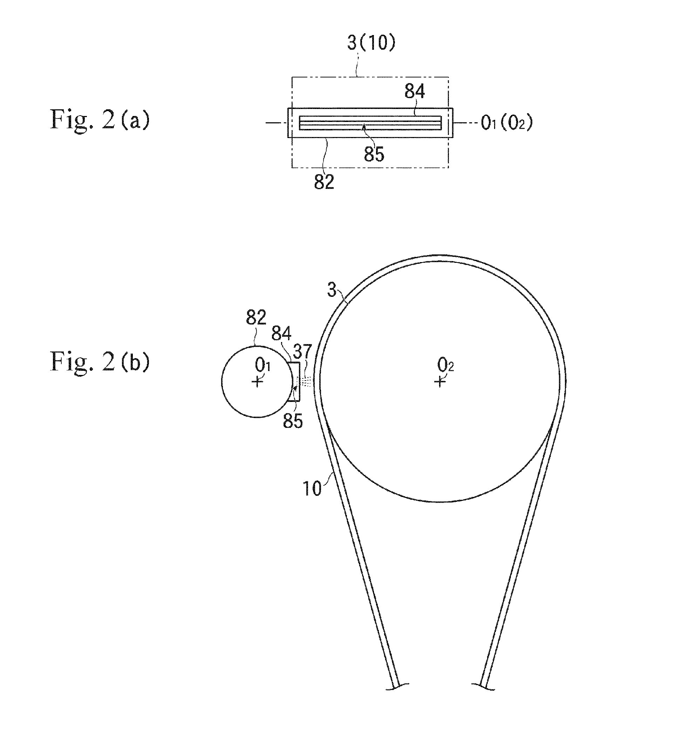

Figs. 2(a) and 2(b) show a vapor emission unit of the vapor emission device, in which Fig. 2(a) is a front view and Fig. 2(b) is a side view.

As shown in Fig. 1(a), a film formation device 1 of the present embodiment forms a film on a film 10 in a vacuum chamber 2.

A center roller 3 having a cylindrical shape which is in contact with the film 10 and transports the film 10 is provided in the vicinity of the central portion inside the vacuum chamber 2; andafilm-reeling-outand-windingchamber4, abufferchamber 5, a film deposition chamber 6 and a curing chamber 7 are provided around the center roller 3.

The film-reeling-out and -winding chamber 4 of the present embodiment is formed by a space surrounded with a first partition wall 11 having a shape of plate folded into multiple stages provided near the center roller 3 and an inner wall on one side (here, lower side in the drawing) of the vacuum chamber 2 relative to the center roller 3.

Here, the first partition wall 11 is made such that a portion near the center roller 3 is formed so as to be near to the side surface and both bottom surfaces of the center roller 3, and thus, the film 10 can pass through a gap between the first partition wall 11 and the side surface of the center roller 3.

A mother roll 41 of the film 10 which is an object to be film-formed is disposed in the film-reeling-out and -winding chamber 4, and a configuration is made such that the film 10 reeled out from the mother roll 41 is made to change its direction and is drawn so as to closely contact with the surface of the center roller 3 and is wound by a winding roller 42 provided in the film-reeling-out and -winding chamber 4.

Furthermore, a static elimination device 43 which removes static electricity of the film 10 after film formation is provided in the film-reeling-out and -winding chamber 4. The static elimination device 43 is a device for preventing the film 10 after film formation from sticking to the center roller 3 due to static electricity.

On the other hand, the buffer chamber 5 is formed by a space surrounded with the first partition wall 11, a second partition wall 12 having a shape of plate folded into multiple stages provided so as to face the first partition wall 11 in the vicinity of the center roller 3, and an inner wall (here, inner walls on right and left sides in the drawing) of the vacuum chamber 2.

Here, the second partition wall 12 is configured such that a portion near the center roller 3 is formed so as to be near to the side surface and both bottom surfaces of the center roller 3; and thus, the film 10 can pass through a gap between the second partition wall 12 and the side surface of the center roller 3.

Moreover, the film deposition chamber 6 is formed by a space surrounded with a third partition wall 13 having a shape folded into multiple stages provided in the interior of the buffer chamber 5, and an inner wall on one side (here, left side in the drawing) of the vacuum chamber 2.

Here, the third partition wall 13 is configured such that a portion near the center roller 3 is formed so as to be near to the side surface and both bottom surfaces of the center roller 3; and thus, the film 10 can pass through a gap between the third partition wall 13 and the side surface of the center roller 3.

In addition, a vapor emission unit 82 of a vapor emission device 8 to be described later is disposed in the film deposition chamber 6.

On the other hand, the curing chamber 7 is formed by a space surrounded with the second partition wall 12, and an inner wall on the other side (here, upper side in the drawing) of the vacuum chamber 2 relative to the center roller 3.

Here, an energy ray-emitting device 9, which emits an energy ray in the direction toward the center roller 3, is provided in a portion that communicate with the curing chamber 7 in the upper portion of the vacuum chamber 2.

The above-discussed film-reeling-out and -winding chamber 4, buffer chamber 5, film deposition chamber 6 and curing chamber 7 are respectively connected to a first to fourth vacuum evacuation devices 40, 50, 60, and 70 which are independently controllable, and are configured so as to be capable of performing differential exhaust between the film-reeling-out and -winding chamber 4 and the buffer chamber 5, between the buffer chamber 5 and the film deposition chamber 6, and between the buffer chamber 5 and the curing chamber 7, via the above-discussed gaps between the first to third partition walls 11 to 13 and the center roller 3.

As shown in Fig. 1(b), the vapor emission device 8 of the present embodiment has a vaporization unit 81 for vaporizing an organic compound monomer 33 in a liquid state, and the vaporization unit 81 is connected to a fifth vacuum evacuation device 80 which is independently controllable from a third vacuum evacuation device 60 in the film deposition chamber 6.

In the case of the present embodiment, a vapor emission unit 82 having, for example, a cylindrical shape is connected to communicate with the vaporization unit 81 via a connection part 81a having bellows, and the vapor emission unit 82 is disposed in the film deposition chamber 6 of the vacuum chamber 2.

On the other hand, a pressure gauge 20 for measuring the pressure in the vaporization unit 81 is provided at the vaporization unit 81, and the pressure gauge 20 is configured to send out the measured pressure information to a control unit 18 having a computer or the like (refer to Fig. 1).

The control unit 18 is electrically connected to a film formation pressure gauge 21 for measuring the pressure in the film deposition chamber 6; and the control unit 18 receives the pressure information in the film deposition chamber 6 measured by the film formation pressure gauge 21.

Furthermore, the control unit 18 is electrically connected to the third vacuum evacuation device 60 which vacuum evacuates the film deposition chamber 6, and the control unit 18 controls the pressure in the film deposition chamber 6 on the basis of the result obtained by the film formation pressure gauge 21 provided in the film deposition chamber 6.

In the present embodiment, for example, a medium circulation path (not shown) is provided in the interior of a housing of the vaporization unit 81, and a medium controlled to have a predetermined temperature is circulated between the medium circulation path and a first temperature-adjusting means 19.

Moreover, for example, a medium circulation path (not shown) is provided in the interior of a housing of the vapor emission unit 82, and a medium controlled to have a predetermined temperature is circulated between the medium circulation path and a second temperature-adjusting means 83.

On the other hand, a monomer supply source 30 is provided in the exterior of the vaporization unit 81, and an organic compound monomer in a liquid state (hereinafter, appropriately referred to as an "organic compound monomer") 33 is introduced from the monomer supply source 30 into the vaporization unit 81 via a pipe 31 and an organic compound introduction part 22.

The monomer supply source 30 of the present embodiment is configured so as to send a rare gas 34 (such as, an inert gas) into the organic compound monomer 33 in a liquid state stored in a vessel 32, and to supply the organic compound monomer 33 to the organic compound introduction part 22 by the pressure of the rare gas via the pipe 31.

The organic compound introduction part 22 of the present embodiment is provided in an upper part of the vaporization unit 81 and has a dispersion unit 22a that disperses the organic compound monomer 33 in a liquid state and sprays the same in a mist state.

On the other hand, a vaporizer 23 which vaporizes the introduced organic compound monomer 33 while transporting the monomer 33 is provided in the lower portion of the dispersion unit 22a in the vaporization unit 81.

The vaporizer 23 has a plurality of (in the present embodiment, four) first to fourth vaporization members 24A, 24B, 24C and 24D which are formed into, for example, a flat plate shape.

The first to fourth vaporization members 24A to 24D of the present embodiment are aligned side-by-side obliquely downward, and are disposed so as to transfer the organic compound monomer 33 from an upper member to a lower member, by inclining each of the members toward one side.

In addition, the first to fourth vaporization members 24A to 24D are configured so as to be able to independently change and adjust the inclination angle.

Each interior of these first to fourth vaporization members 24A to 24D is provided with a medium circulation path (not shown), and is connected to each of a third to sixth temperature-adjusting means 26, 27, 28, and 29 based on a medium circulation systems that are independently controllable.

In the present embodiment, the organic compound monomer 33 is transferred from the first vaporization member 24A of the uppermost stage to the second vaporization member 24B positioned below, the organic compoundmonomer 33 is transferred from the second vaporization member 24B to the third vaporization member 24C positioned below, and furthermore, the organic compound monomer 33 is transferred from the third vaporization member 24C to the fourth vaporization member 24D positioned below.

Then, in the vaporization unit 81 having such configuration, the organic compound monomer 33 is heated and vaporized when the organic compound monomer 33 is transported and transferred.

On the other hand, a rare gas supply source 35 is provided outside the vaporization unit 81, and a rare gas (such as, an inert gas) sent from the rare gas supply source 35 is introduced into the vaporization unit 81 via a mass flow controller 36.

In the case of the present embodiment, the mass flow controller 36 is connected to the control unit 18 to thereby control the introduction amount of the rare gas on the basis of the result obtained by the pressure gauge 20 and the film formation pressure gauge 21.

As shown in Fig. 1 (b) and Figs. 2 (a) and 2(b), the vapor emission unit 82 formed into a cylindrical shape of the vapor emission device 8 of the present embodiment is a member to which a vapor 37 of the organic compound monomer is sent from the vaporization unit 81, and is configured such that the inner pressure becomes identical to the pressure in the vaporization unit 81.

In addition, the vapor emission unit 82 has an emission unit 84 formed linearly along the longitudinal direction thereof, and a linear slit-shaped vapor-emitting port 85 is provided in the emission unit 84. Here, the vapor emission unit 82 is disposed such that a rotation axis line O₁ thereof becomes parallel to a rotation axis line O₂ of the center roller 3, and so that the vapor-emitting port 85 is disposed facing close to the film 10 on the center roller 3, in parallel to these rotation axis lines O₁ and O₂.

Furthermore, the vapor-emitting port 85 is formed to have a width slightly smaller than the width of the center roller 3 (the -film 10), and is configured so as to blow linearly the vapor 37 of the organic compound monomer in relation to the surface of the film 10 in the width direction.

In the present embodiment having such a configuration, in the case of forming a polymer organic compound film on the film 10 in the vacuum chamber 2, the fifth vacuum evacuation device 80 is operated and the interior of the vaporization unit 81 of the vapor emission device 8 is vacuum evacuated so as to give a pressure of a predetermined value, and the first to fourth vacuum evacuation devices 40, 50, 60 and 70 are operated and the pressures of the film-reeling-out and -winding chamber 4, the buffer chamber 5, the film deposition chamber 6, and the curing chamber 7 are made so as to be predetermined values respectively.

In this case, the second to the fourth vacuum evacuation devices 50 to 70 are operated respectively in a manner such that the pressure of the buffer chamber 5 is larger than the pressure of the curing chamber 7 and the pressure of the film deposition chamber 6 is larger than the pressure of the buffer chamber 5 to thereby perform differential exhaust.

Furthermore, the first and second vacuum evacuation devices 40 and 50 are operated respectively so that the pressure of the film-reeling-out and -winding chamber 4 becomes larger than the pressure of the buffer chamber 5 to thereby perform differential exhaust.

On the other hand, in the vapor emission device 8, inclination angles of the first to fourth vaporization members 24A to 24D in the vaporization unit 81 are set to be predetermined angles, and the temperatures of the first to fourth vaporization members 24A to 24D are controlled to be predetermined temperatures, respectively, by operating the third to sixth temperature-adjusting means 26 to 29.

In addition, the temperature of the vapor emission unit 82 is controlled to be a predetermined temperature by operating the second temperature-adjusting means 83.

In this state, the rare gas of a predetermined amount is introduced into the vaporization unit 81 from the rare gas supply source 35 via the mass flow controller 36, and a predetermined amount of the organic compound monomer 33 in a liquid state is introduced into the vaporization unit 81 from the monomer supply source 30 via the piping 31 and the organic compound introduction part 22.

Thereby, the organic compound monomer 33 in a mist state is supplied to the first vaporization member 24A of the upper stage from the upper portion, by the dispersion unit 22a provided in the upper part of the vaporization unit 81.

The supplied organic compound monomer 33 is transferred from the first vaporization member 24A to the second vaporization member 24B, is transferred from the second vaporization member 24B to the third vaporization member 24C, and is further transferred from the third vaporization member 24C to the fourth vaporization member 24D; and the organic compound monomer 33 is heated and vaporized at the time of the transport and transfer.

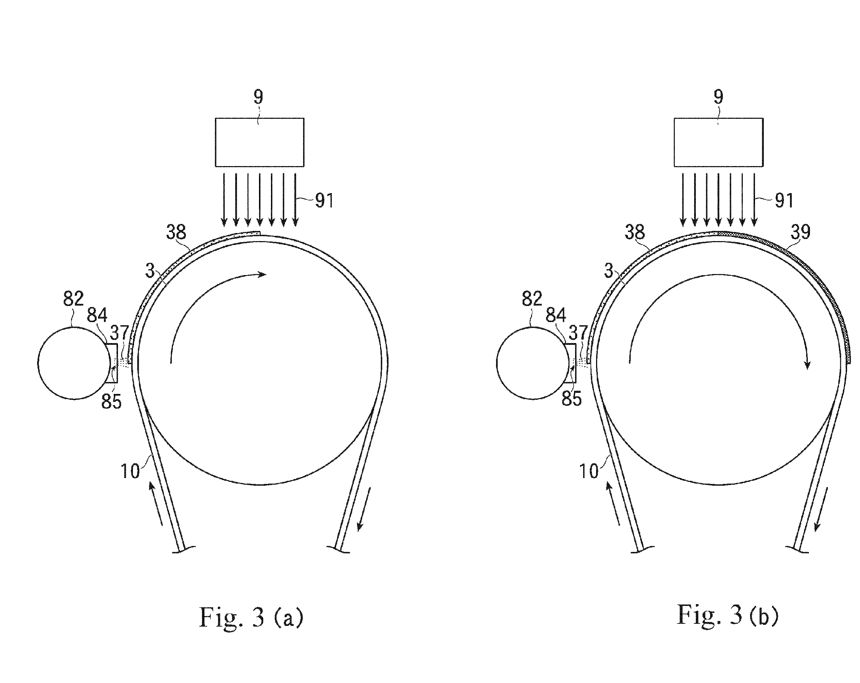

The vaporized organic compound monomer 33 is sent to the vapor emission unit 82 and is blown out from the vapor-emitting port 85 of the vapor emission unit 82; and as shown in Fig. 3 (a), the vapor 37 of an organic compound monomer is blown to the film 10 transported in contact with the center roller 3 and an organic compound monomer layer 38 is deposited on the film 10.

In the present embodiment, the vacuum evacuation is performed in such a manner that, when blowing the vapor 37 of an organic compound monomer, the pressure in the vapor emission device 8 (vaporization unit 81 andvaporemissionunit 82) becomes larger than the pressure in the film deposition chamber 6, and the difference between the pressure in the vapor emission device 8 and the pressure in the film deposition chamber 6 becomes constant.

Specifically, based on a command from the control unit 18, the third vacuum evacuation device 60 is operated on the basis of the result obtained by the film formation pressure gauge 21 to thereby control the pressure in the film deposition chamber 6 to be a predetermined value, and the mass flow controller 36 is operated on the basis of the result obtained by the pressure gauge 20 to thereby control the introduction amount of the rare gas to be introduced into the vaporization unit 81 and to thereby control the pressure of the vaporization unit 81 to a predetermined value.

Then, while transporting the film 10, an energy ray 91 is emitted from the energy ray-emitting device 9 so as to cure the organic compound monomer layer 38 on the film 10 in the curing chamber 7 as shown in Fig. 1(a), and the polymer organic compound layer 39 is formed (refer to Figs. 3(a) and 3(b)).

Finally, the film 10 is subjected to static elimination in the film-reeling-out and -winding chamber 4 and the film 10 is wound by the winding roller 42.

In the present embodiment discussed above, when the vapor 37 of an organic compound monomer is emitted from the vapor emission unit 82 of the vapor emission device 8 and is blown to the film 10 on the center roller 3, the vacuum evacuation is performed such that the pressure in the vapor emission device 8 is made larger than the pressure in the film deposition chamber 6 and the difference between the pressure in the vapor emission device 8 and the pressure in the film deposition chamber 6 becomes constant; and thus, the organic compound monomer layer 38 having a uniform thickness can be formed on the film 10 transported by the center roller 3.

As a result, according to the present embodiment, the polymer organic compound layer 39 having a uniform thickness can be formed by irradiating the organic compound monomer layer 38 having a uniform thickness with the energy ray 91 to thereby polymerize and cure the organic compound monomer layer 38.

In addition, in the present embodiment, because the flow amount of a rare gas controlled to a predetermined temperature is controlled by the mass flow controller 36 and the rare gas is supplied to the vapor emission device 8, the pressure in the vapor emission device 8 can easily be set to be larger than the pressure in the film deposition chamber 6; and thus, the film formation speed can be enhanced by making the pressure difference between the vapor emission device 8 and the film deposition chamber 6 large.

Furthermore, in the present embodiment, because the curing chamber 7 in which the energy ray-emitting device 9 is disposed and the buffer chamber 5 communicated with the curing chamber 7 and the film deposition chamber 6 are provided in the vacuum chamber 2, and because the curing chamber 7 and the buffer chamber 5 are respectively connected to the fourth and second vacuum evacuation devices 70 and 50 which are independently controllable, differential exhaust with a large pressure difference can be performed not only between the vapor emission device 8 and the film deposition chamber 6 but also between the film deposition chamber 6, the buffer chamber 5 and the curing chamber 7; and thus, the film formation speed can be enhanced by making the pressure difference between respective chambers large.

Moreover, in the present embodiment, because the first to fourth vaporization members 24A to 24D of the vaporizer 23 are respectively connected to the third to sixth temperature-adjusting means 26 to 29 based on a medium circulation system which are independently controllable, organic compound monomers 33 having various vaporization temperatures can be vaporized under the optimal condition.

Furthermore, in the present embodiment, because the inclination angles of the first to fourth vaporization members 24A to 24D can be changed and individually adjusted, organic compound monomers 33 of various viscosities can be transported and transferred so as to be vaporized, under the optimal condition.

In addition, in the present embodiment, because the first and second vacuum evacuation devices 40 and 50 are operated such that the pressure in the film-reeling-out and -winding chamber 4 becomes larger than the pressure in the buffer chamber 5 at the time of film formation, the intrusion of the vapor 37 of the organic compound monomer from the buffer chamber 5 to the film-reeling-out and -winding chamber 4 can be prevented.

The present invention is not limited to the above-discussed embodiments but various modifications can be performed.

For example, a vaporizer of a vapor emission device is not limited to the above-discussed embodiment, and vaporizers of various types can be used as long as they can vaporize a low-molecular-weight organic compound.

However, through the use of the vaporizer of the above-discussed embodiment, organic compounds having various vaporization temperatures can be vaporized under an optimal condition, and organic compounds having various viscosities can be transported and transferred so as to be vaporized under an optimal condition.

In addition, the kind of organic compound to be a raw material of a film in the present invention is not particularly limited, and the invention can be applied to various organic compounds.

Furthermore, the kind, thickness or the like of the film for use in the film formation in the invention is also not particularly limited; and the invention can be applied to various films.

### Explanation of Reference Numerals

1. film formation device
2. vacuum chamber
3. center roller
4. film-reeling-out and -winding chamber
5. buffer chamber
6. film deposition chamber
7. curing chamber
8. vapor emission device
10. film
18. control unit
19. first temperature-adjusting means
20. pressure gauge
21. film formation pressure gauge
22. organic compound introduction part
22a. dispersion unit
23. vaporizer
24A, 24B, 24C, 24D. first to fourth vaporization member
26, 27, 28, 29. third to sixth temperature-adjusting means
30. monomer supply source
33. organic compound monomer
35. rare gas supply source
36. mass flow controller
37. vapor of organic compound monomer
40, 50, 60, 70, 80. first to fifth vacuum evacuation device
41. mother roll
81. vaporization unit
82. vapor emission unit
85. vapor-emitting port
O₁, O₂. rotation axis line

## Claims

1. A film formation device for transporting a film reeled out from a mother roll in contact with a center roller and forms an organic compound film on the film, in a vacuum chamber, the device comprising:
a vapor emission device disposed in a film deposition chamber provided in the vacuum chamber and having a vapor emission unit which emits and blows a vapor of an organic compound to a film on the center roller; and
an energy ray-emitting device for irradiating an organic compound layer formed on the center roller with an energy ray so as to cure the organic compound layer,
wherein the vapor emission device and the film deposition chamber are respectively connected to vacuum evacuation devices which are independently controllable; and
wherein vacuum evacuation is performed in a manner such that pressure in the vapor emission device becomes larger than pressure in the film deposition chamber, and difference between the pressure in the vapor emission device and the pressure in the film deposition chamber becomes constant.

2. The film formation device according to claim 1, wherein a flow amount of a rare gas, which is controlled to a predetermined temperature, is controlled and supplied to the vapor emission device.

3. The film formation device according to any one of claims 1 and 2, further comprising:
a curing chamber in which the energy ray-emitting device is disposed, the curing chamber being in the vacuum chamber; and
a buffer chamber that communicates with the curing chamber and the film deposition chamber provided in the vacuum chamber,
wherein the curing chamber and the buffer chamber are respectively connected to vacuum evacuation devices which are independently controllable.
